# EUROPEAN PATENT APPLICATION

(11) **EP 2 051 305 A1**
(43) Date of publication of application: **22.04.2009**
(21) Application number: 07791661.7
(22) Date of filing: 31.07.2007
(51) Int. Cl.: H01L 31/04

(54) **SOLAR CELL MODULE**

(30) Priority: 31.07.2006 JP 2006208787
(71) Applicant: Sanyo Electric Co., Ltd., Osaka 570-8677 (JP)
(72) Inventor: YAGIURA, Toshio, - (JP)
(74) Representative: Calderbank, Thomas Roger
(86) International application number: PCT/JP2007/064976
(87) International publication number: WO 2008/016042

(57) **Abstract**

In a solar cell module, multiple photovoltaic elements, a bonding layer 16; and a back surface film 17 are arranged in this order on a transparent substrate 11 on a back surface side opposite to a light incident surface side. Each of the multiple photovoltaic element is formed by stacking in sequence a transparent conductive film 12, photoelectric conversion layers 13 and 14, and a back surface electrode 15. The photoelectric conversion layer 13 covers a surface on the back surface side of the transparent conductive film 12 in an area where the back surface electrodes 15 of the adjacent photovoltaic elements are electrically isolated from each other.

## Description

### TECHNICAL FIELD

The present invention relates to a solar cell module including a photovoltaic element and a bonding layer, the photovoltaic element formed by stacking in sequence a first electrode, a photoelectric conversion layer, and a second electrode.

### BACKGROUND ART

Recently, a thin-film solar cell module requiring a small amount of raw material has been intensively developed to simultaneously achieve low cost and high efficiency of a solar cell.

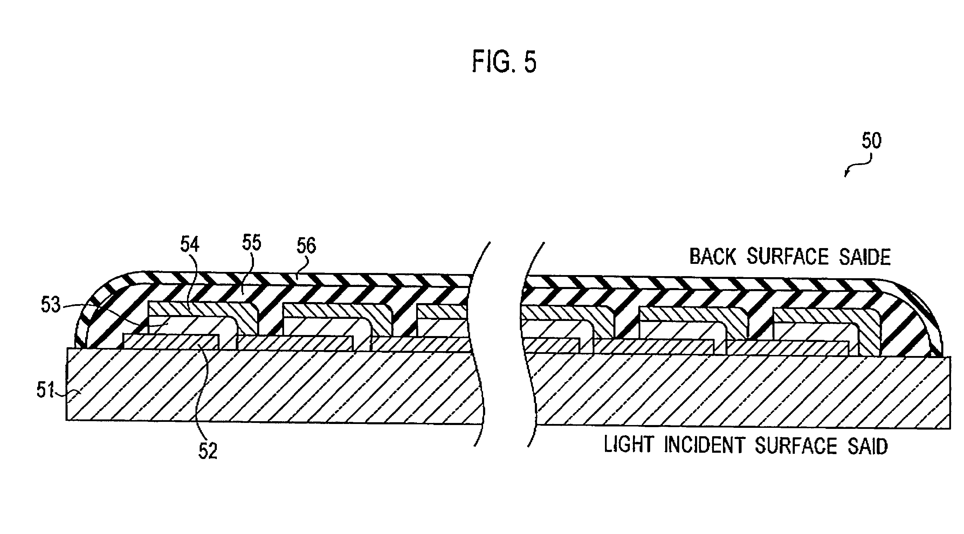

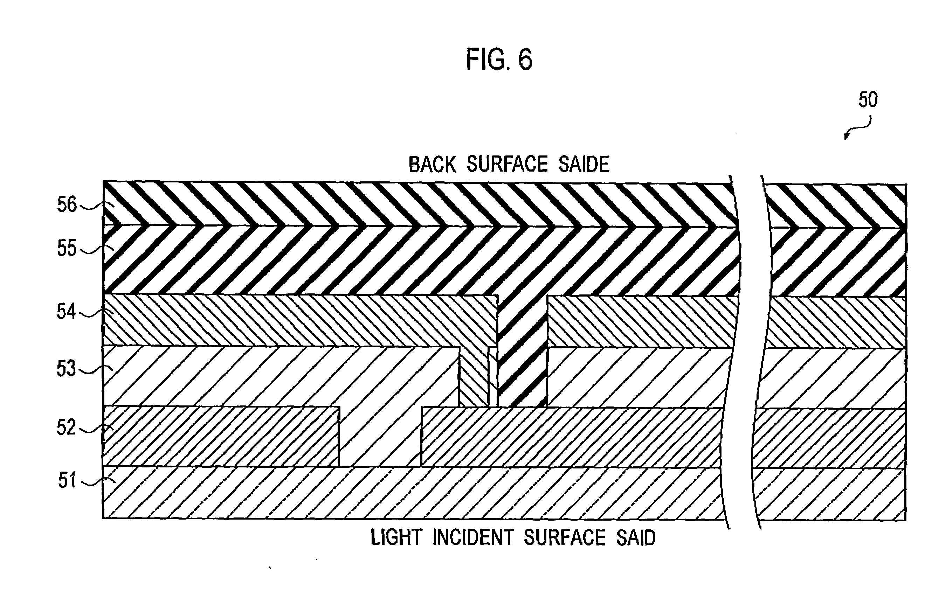

Figs. 5 and 6 show cross-sectional views of a conventional thin-film solar cell module 50. Fig. 6 is an enlarged cross-sectional view of Fig. 5.

With a view to enhancing manufacturing efficiency or the like, a photovoltaic element of the thin-film solar cell module 50 is generally formed by stacking in sequence a transparent conductive film 52, a photoelectric conversion layer 53, and a back surface electrode 54 on an impermeable transparent substrate 51 formed of glass or the like, while patterning them by laser irradiation from the side of the transparent substrate 51. Further, the thin-film solar cell module 50 is formed by bonding a back surface film 56 such as PET (Poly Ethylene Terephtalate) on the photovoltaic element with a bonding layer 55 such as EVA (Ethylene Vinyl Acetate) (refer to Patent Document 1, for example).

In this manner, the bonding layer 55 is in contact with the transparent conductive film 52 in the conventional thin-film solar cell module 50, since the back surface electrode 54 is patterned by laser irradiation from the side of the transparent substrate 51.

Here, the bonding layer 55 serves as an adhesive agent and a buffering agent between the back surface film 56 and the photovoltaic element. The back surface film 56 has a function of preventing moisture from penetrating from outside.
Patent Document 1: Japanese Patent Application Publication No. Hei 8-204217

### DISCLOSURE OF THE INVENTION

In general, solar cell modules are often used outside. Thus, they are required to have weather resistance high enough to maintain a stable and high power generating capacity even under severe weather conditions.

In particular, a thin-film solar cell module needs to have a structure capable of maintaining a stable and high power generating capacity even if moisture penetrates, since the material of a thin film may possibly deteriorate easily due to moisture penetration from outside or the like.

However, some kind of material or structure of the back surface film 56, such as PET, for blocking moisture penetration from outside may fail to completely block moisture penetration. If the moisture having permeated the bonding layer 55 reaches the transparent conductive film 52, the transparent conductive film 52 easily deteriorates. AS a result, there is a problem that a solar cell module is not capable of maintaining a stable and high power generating capacity.

The present invention has been made in light of the above problem, and an object thereof is to provide a thin-film solar cell module capable of maintaining a stable and high power generating capacity even if moisture penetrates.

A feature of the present invention provides a solar cell module formed by disposing in sequence a photovoltaic layer and a bonding layer, the photovoltaic layer formed by connecting in series multiple photovoltaic elements each of which is formed by stacking in sequence a first electrode, a photoelectric conversion layer, and a second electrode on a transparent substrate on a back surface side opposite to a light incident surface side, in which, in an area where the second electrodes of the adjacent photovoltaic elements are electrically isolated from each other, the photoelectric conversion layer covers a surface on the back surface side of the first electrode.

The thin-film solar cell module according to the feature of the present invention is capable of maintaining a stable and high power generating capacity even when moisture penetrates from the back surface side of the solar cell module.

In the thin-film solar cell module according to the feature of the present invention, it is preferable that the part of the photoelectric conversion layer covering the first electrode be an amorphous silicon semiconductor layer. With the amorphous silicon semiconductor layer having high impermeability, the thin-film solar cell module is capable of blocking moisture having penetrated, so that the module is capable of maintaining a more stable and higher power generating capacity.

The first electrode of the thin-film solar cell module according to the feature of the present invention may be mainly composed of zinc oxide. In accordance with the thin-film solar cell module according to the feature of the present invention, zinc oxide, which easily deteriorates due to moisture although it has advantages in terms of optical property, electrical property, and cost, is able to be preferably used as the material of the transparent conductive film.

It is preferable that the photovoltaic layer of the thin-film solar cell module according to the feature of the present invention be electrically isolated into multiple photovoltaic elements by laser patterning.

### BRIEF DESCRIPTION OF THE DRAWINGS

[Fig. 1] Fig. 1 is an enlarged sectional view showing a configuration of a thin-film solar cell module 10 according to this embodiment.
[Fig. 2] Fig. 2 is a cross-sectional view (Part 1) for explaining a manufacturing method of the thin-film solar cell module 10 according to this embodiment.
[Fig. 3] Fig. 3 is a cross-sectional view (Part 2) for explaining the manufacturing method of the thin-film solar cell module 10 according to this embodiment.
[Fig. 4] Fig. 4 is a graph showing a result of a humidity test for the thin-film solar cell module 10 according to this embodiment and a thin-film solar cell module 50 according to a conventional example.
[Fig. 5] Fig. 5 is a cross-sectional view showing a configuration of the conventional thin-film solar cell module 50.
[Fig. 6] Fig. 6 is an enlarged cross-sectional view showing the configuration of the conventional thin-film solar cell module 50.

### BEST MODES FOR CARRYING OUT THE INVENTION

Next, an embodiment of the present invention will be described by using the drawings. In the descriptions of the drawings below, the same or similar portions are denoted by the same or similar reference numerals. However, it should be noted that the drawings are schematic, and proportions of sizes and the like therein are different from actual ones. Thus, specific sizes and the like should be determined in light of the following description. Needless to say, there are portions where relationships or proportions of sizes of the drawings are different from one another.

### (Solar Cell Module)

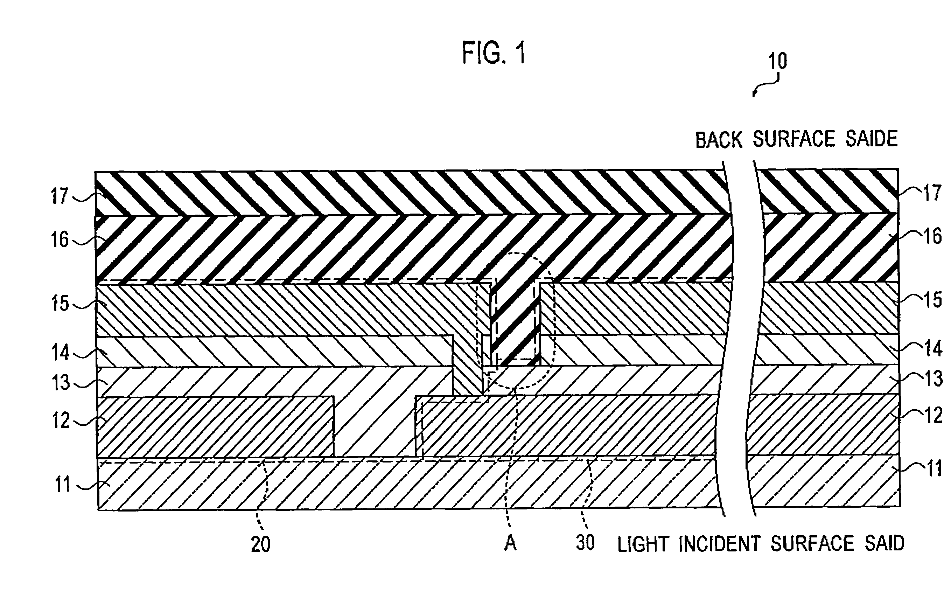

As shown in Fig. 1, in a thin-film solar cell module 10, multiple photovoltaic elements, a bonding layer 16, and a back surface film 17 are disposed in sequence on a transparent substrate 11 on a back surface side opposite to a light incident surface side. The multiple photovoltaic elements are each formed by stacking in sequence a transparent conductive film 12, photoelectric conversion layers 13 and 14, and a back surface electrode 15.

The transparent substrate 11 is a single substrate for the solar cell module. The transparent substrate 11 has a back surface and a light incident surface opposite to the back surface. The multiple photovoltaic elements are formed on the back surface. The transparent substrate 11 is formed of a light transmissive material such as glass.

The transparent conductive film 12 (a first electrode) is formed in a rectangle shape on the transparent substrate 11. The transparent conductive film 12 consists of a single type or multiple types of stacked bodies selected from a group of metal oxides obtained by doping ZnO, In₂O₃, SnO₂, CdO, TiO₂, CdIn₂O₄, Cd₂SnO₄, and Zn₂SnO₄ with Sn, Sb, F, and Al. Incidentally, ZnO is preferable as a transparent conductive film material since it has high optical transparency, low resistance, and plasticity, and is inexpensive. In this embodiment, ZnO is used for the transparent conductive film.

The photoelectric conversion layers 13 and 14 are formed in a rectangle shape on the transparent conductive film 12. The photoelectric conversion layers 13 and 14 are each formed of a crystalline or amorphous silicon semiconductor. The photoelectric conversion layers 13 and 14 according to this embodiment are formed of an amorphous silicon semiconductor and a microcrystalline silicon semiconductor, respectively. Incidentally, in this description, the term "microcrystalline" represents a state in which numbers of minute crystal grains are included, and also a state in which an amorphous state is partially included.

The back surface electrode 15 is formed in a rectangle shape on the photoelectric conversion layers 13 and 14. The back surface electrode 15 is formed of a conductive material such as Ag.

As described above, the photovoltaic elements are formed by stacking in sequence the transparent conductive film 12, the photoelectric conversion layers 13 and 14, and the back surface electrode 15 on the transparent substrate 11.

The back surface film 17 is disposed on the bonding layer 16. The back surface film 17 is formed of a resin film such as PET, PEN, ETFE, PVDF, or PVF. The back surface film 17 has a function of preventing moisture from penetrating from outside as much as possible.

The back surface film 17 is bonded to the photovoltaic element with the bonding layer 16 interposed therebetween. The bonding layer 16 is formed of resin such as EVA, EEA, PVB, silicon, urethane, acrylic, or epoxy. The bonding layer 16 serves as an adhesive agent and a buffering agent between the back surface film 17 and the photovoltaic element.

### (Photovoltaic Element)

Next, a configuration of the photovoltaic element according to this embodiment will be described by using Fig. 1.

The photovoltaic element according to this embodiment is formed by stacking in sequence the transparent conductive film 12, the photoelectric conversion layers 13 and 14, and the back surface electrode 15 on the transparent substrate 11.

Here, the photoelectric conversion layer 13 according to this embodiment is formed by stacking in sequence a p-i-n amorphous silicon semiconductor. The photoelectric conversion layer 14 is formed by stacking in sequence a p-i-n microcrystalline silicon semiconductor. In this manner, a tandem type solar cell module formed by using amorphous silicon and microcrystalline silicon having different light absorption wavelengths is capable of effectively using solar spectrum.

For the sake of simplifying the following description, two photovoltaic elements in Fig. 1 will be described while defining a left side one as a first photovoltaic element 20, and a right side one as a second photovoltaic element 30.

The transparent conductive film 12 of the first photovoltaic element 20 and that of the second photovoltaic element 30 are electrically isolated from each other. The back surface electrode 15 of the first photovoltaic element 20 and that of the second photovoltaic element 30 are electrically isolated from each other. The photoelectric conversion layers 13 and 14 of the first photovoltaic element 20 and those of the second photovoltaic element 30 are electrically isolated from each other, respectively.

The back surface electrode 15 of the first photovoltaic element 20 is electrically connected to the transparent conductive film 12 of the second photovoltaic element 30 through an area by which the photoelectric conversion layers 13 and 14 are isolated.

In this manner, the first photovoltaic element 20 and the second photovoltaic element 30 are electrically connected to each other in series, so that electric current flows in one direction.

Here, in the photovoltaic element according to this embodiment, the photoelectric conversion layer 13 of the second photovoltaic element 30 covers the back surface of the transparent conductive film 12 of the second photovoltaic element 30 in an area A by which the back surface electrode 15 is electrically isolated between the first photovoltaic element 20 and the second photovoltaic element 30.

More specifically, in the area A, the photoelectric conversion layer 14 of the second photovoltaic element 30 is removed, while the photoelectric conversion layer 13 thereof is left without being removed. Therefore, the photoelectric conversion layer 13 of the second photovoltaic element 30 is brought into contact with a side surface of a portion, through which the back surface electrode 15 of the first photovoltaic element 20 is connected to the transparent conductive film 12 of the second photovoltaic element 30, of the back surface electrode 15 of the first photovoltaic element 20. In other words, a bottom surface of an isolation groove through which the back surface electrode 15 is isolated in a rectangle shape is formed by the photoelectric conversion layer 13.

The description has been provided for the first photovoltaic element 20 and the second photovoltaic element 30, separately. However, in the thin-film solar cell module 10 according to this embodiment, multiple photovoltaic elements each having a configuration described above are connected on the transparent substrate 11.

### (Manufacturing Method of Solar Cell Module)

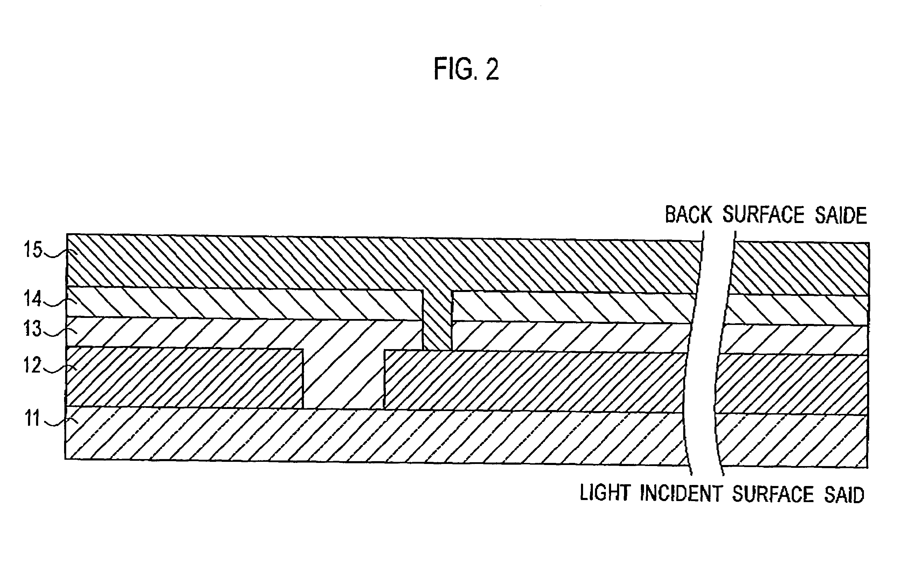

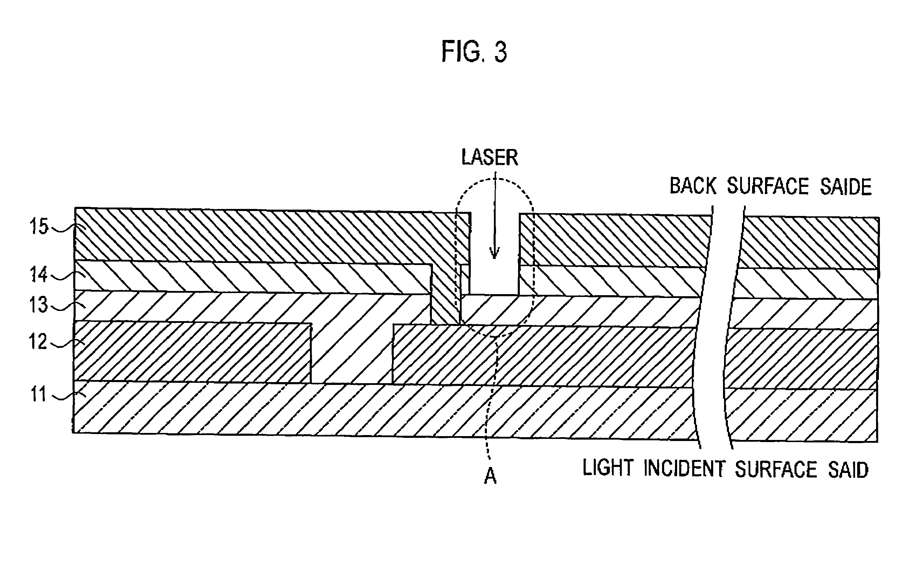

A manufacturing method of the thin-film solar cell module according to this embodiment will be described with reference to Figs. 2 and 3.

As shown in Fig. 2, the transparent conductive film 12 is formed on the transparent substrate 11 by sputtering. The transparent conductive film 12 is patterned in a rectangle shape by YAG laser irradiation, and is electrically isolated between the photovoltaic elements. Incidentally, in this embodiment, a ZnO electrode is used as the transparent conductive film 12.

Next, the photoelectric conversion layers 13 and 14 are formed by using a plasma CVD method. To be more precise, on the transparent conductive film 12, p-i-n amorphous silicon semiconductors are stacked in sequence so as to form the photoelectric conversion layer 13. Thereafter, on the photoelectric conversion layer 13 thus formed, p-i-n microcrystalline silicon semiconductors are stacked in sequence so as to form the photoelectric conversion layer 14. The photoelectric conversion layers 13 and 14, on a position away from a position where the transparent conductive film 12 is patterned, are irradiated with YAG laser so as to be respectively patterned in a rectangle shape.

Subsequently, the back surface electrode 15 is formed on the photoelectric conversion layer 14 by sputtering or the like. The back surface electrode 15 is also formed in an area from which the photoelectric conversion layers 13 and 14 are removed by the patterning. Thereby, the photovoltaic elements are electrically connected to each other in series. Fig. 2 shows a state in which the back surface electrode 15 is formed on the photoelectric conversion layer 14.

Then, the back surface electrode 15, on a position a predetermined distance away from a position where the photoelectric conversion layers 13 and 14 are patterned, is irradiated from the back surface side with YAG laser so as to be patterned in a rectangle shape, as shown in Fig. 3. Thereafter, dry etching is performed up to a desired depth. In this embodiment, dry etching is performed up to a degree of depth by which the microcrystalline silicon semiconductor having high conductivity is removed. Thus, the back surface electrode 15 is electrically isolated in a rectangle shape, and, in an area A by which the back surface electrode 15 is electrically isolated in a rectangle shape, the back surface of the transparent conductive film 12 is covered with the photoelectric conversion layer 13. More specifically, in the area A by which the back surface electrode 15 is electrically isolated in a rectangle shape, the photoelectric conversion layer 14 is removed by laser and etching while the photoelectric conversion layer 13 is not removed. Therefore, the photoelectric conversion layer 13 is retained in a state of coming in contact with side surfaces of a portion, through which the back surface electrode 15 is connected to the transparent conductive film 12, of the back surface electrode 15. In other words, a bottom surface of an isolation groove through which the back surface electrode 15 is isolated in a rectangle shape is formed by the photoelectric conversion layer 13. Fig. 3 shows a state in which the photoelectric conversion layer 13 formed of the amorphous silicon semiconductor covers the transparent conductive film 12 in the area A by which the back surface electrode 15 is electrically isolated.

Next, an external electrode is attached with ultrasonic soldering and copper foil lead.

Subsequently, the bonding layer 16 and the back surface film 17 are arranged in sequence on the photovoltaic element, and they are heated under vacuum and pressure bonded by using a laminating apparatus. Thereby, the back surface of the photovoltaic element is protected.

In the manner described above, the thin-film solar cell module 10 according to this embodiment as shown in Fig. 1 is formed. Additionally, a terminal box and an external electrode are connected to the solar cell module 10. Incidentally, an aluminum frame can be attached to the solar cell module 10 with Butyl rubber or the like interposed therebetween.

### (Operation and Advantages)

According to the thin-film solar cell module 10 of this embodiment, the photoelectric conversion layer 13 covers a surface on the back surface side of the transparent conductive film 12 in the area A for electrically isolating the back surface electrodes 15 of the adjacent photovoltaic elements from each other.

As shown in Fig. 6, in the conventional thin-film solar cell module 50, the back surface electrode 54 is patterned by laser irradiation from the side of the transparent substrate 51 for the purpose of enhancement of manufacturing efficiency or the like. Thus, the bonding layer 55 is disposed on the transparent conductive film 52.

By contrast, in the thin-film solar cell module 10 according to this embodiment, as shown in Fig. 1, the photoelectric conversion layer 13 covers a surface on the back surface side of the transparent conductive film 12 in the area A for electrically isolating the back surface electrodes 15 of the adjacent photovoltaic elements from each other.

Accordingly, even when moisture penetrates from outside, stable and high power generating capacity can be maintained. More specifically, moisture having permeated the back surface film 17 and the bonding layer 16 from the back surface side of the solar cell module 10 is blocked with the photoelectric conversion layer 13, so that the moisture does not reach the transparent conductive film 12. As a result, a thin film material, particularly the transparent conductive film 12 can be prevented from deteriorating due to moisture penetration from outside.

Further, as in this embodiment of the present invention, in the case where the photoelectric conversion layer 13 covering the transparent conductive film 12 is formed of an amorphous silicon semiconductor having impermeable property and low conductivity, moisture penetration can be more suppressed and the leakage of electric current is less likely to occur compared with the case where the photoelectric conversion layer 13 is formed of a crystalline silicon semiconductor.

Furthermore, as in this embodiment of the present invention, when the transparent conductive film 12 is formed of ZnO, the transparent conductive film 12 is more likely to deteriorate by moisture compared with other metal oxides. That is, as a material for the transparent conductive film, ZnO has advantages over other metal oxides in terms of optical property, electrical property, and cost, while it has a property of easily deteriorating by moisture.

According to this embodiment, the photoelectric conversion layer 13 covers the transparent conductive film 12, thereby preventing moisture penetration. Thus, ZnO having great advantages as the material of the transparent conductive film 12 can be used.

Further, in the thin-film solar cell module 10 according to this embodiment, a photovoltaic layer formed by connecting multiple photovoltaic elements to each other in series can be electrically isolated into multiple photovoltaic elements by laser patterning.

### (Other Embodiments)

The present invention has been described by using the above embodiment. However, it should not be understood that the descriptions and drawings constituting a part of this disclosure will limit the present invention. Various alternative embodiments, examples, and operational techniques will be apparent to those skilled in the art from this disclosure.

For example, in the above embodiment, the photoelectric conversion layers 13 and 14 formed by stacking in sequence an amorphous silicon semiconductor and a microcrystalline silicon semiconductor are used. However, the same effect can be achieved by using a stacked body formed of a single layer of the microcrystalline silicon semiconductor or the amorphous silicon semiconductor, or more than two layers of the microcrystalline silicon semiconductor and the amorphous silicon semiconductor.

Further, in the above embodiment, only the photoelectric conversion layer 13 covers the transparent conductive film 12 in the area A for electrically isolating the back surface electrodes 15 of the adjacent photovoltaic elements from each other. However, when the photoelectric conversion layer 14 has low electric conductivity, the same effect can be achieved when the photoelectric conversion layer 14 covers the photoelectric conversion layer 13.

Furthermore, ZnO is used for the transparent conductive film 12. However, the present invention is not limited to this. Alternatively, it is also possible to use a stacked body formed of a single type or multiple types selected from a group of metal oxides obtained by doping In₂O₃, SnO₂, CdO, TiO₂, CdIn₂O₄, Cd₂SnO₄, and Zn₂SnO₄ with Sn, Sb, F, and Al.

Still furthermore, in the above embodiment, dry etching is used in the isolation processing of the back surface electrode 15. However, wet etching or the like may also be used.

As has been described, it is needless to say that the present invention includes various embodiments and the like that are not described herein. Accordingly, the technical scope of the present invention is defined only by the inventive specified matters according to the scope of claims which are appropriate from the above descriptions.

### EXAMPLES

The thin-film solar cell module according to the present invention will be more specifically described below with reference to the following example. However, the present invention is not limited to the following example, and various modifications can be made as needed without deviating from the gist thereof.

### (Example)

A thin-film solar cell module according to an example of the present invention was manufactured as follows.

As shown in Fig. 1, on a glass substrate 11 having a thickness of 4 mm, a ZnO electrode 12 having a thickness of 600 nm was formed by sputtering. The ZnO electrode 12 was irradiated with YAG laser from the light incident surface of the glass substrate 11 so that the ZnO electrode 12 would be patterned in a rectangle shape to be electrically isolated. In the laser isolation processing, used was Nd:YAG laser with a wavelength of about 1.06 µm, an energy density of 13 J/cm³, and a pulse frequency of 3 kHz.

Next, by using a plasma CVD method, an amorphous silicon semiconductor layer 13 and a microcrystalline silicon semiconductor layer 14 were formed. To be more precise, the amorphous silicon semiconductor layer 13 was formed by using a plasma CVD method by stacking in sequence a p-type amorphous silicon semiconductor layer, having a film thickness of 10 nm, formed of mixed gas of SiH₄, CH₄, H₂, and H₂H₆; an i-type amorphous silicon semiconductor layer, having a film thickness of 300 nm, formed of mixed gas of SiH₄ and H₂; and an n-type amorphous silicon semiconductor layer, having a film thickness of 20 nm, formed of mixed gas of SiH₄, H₂, and PH₃. Further, the microcrystalline silicon semiconductor layer 14 was formed by using a plasma CVD method by stacking in sequence a p-type microcrystalline silicon semiconductor layer, having a film thickness of 10 nm, formed of mixed gas of SiH₄, H₂, and B₂H₆; an i-type microcrystalline silicon semiconductor layer, having a film thickness of 2000 nm, formed of mixed gas of SiH₄ and H₂; and an n-type microcrystalline silicon semiconductor layer, having a film thickness of 20 nm, formed of mixed gas of SiH₄, H₂, and PH₃. Conditions of the plasma CVD method are shown in detail in Table 1.

**[Table 1]**

| Table of Plasma CVD Conditions | | | | | | |
|---|---|---|---|---|---|---|
| | Layer | Substrate temperature (degree C) | Gas flow (sccm) | Reaction pressure (Pa) | RF power (W) | Film thickness (nm) |
| a-Si film | p layer | 180 | SiH₄:300 CH₄:300 H₂:2000 B₂H₆:3 | 106 | 10 | 10 |
| | i layer | 200 | SiH₄:300 H₂:2000 | 106 | 20 | 300 |
| | n layer | 180 | SiH₄:300 H₂:2000 PH₃:5 | 133 | 20 | 20 |
| Microcrystalline Si film | p layer | 180 | SiH₄:10 H₂:2000 B₂H₆:3 | 106 | 10 | 10 |
| | i layer | 200 | SiH₄:100 H₂:2000 | 133 | 20 | 2000 |
| | n layer | 200 | SiH₄:10 H₂:2000 PH₃:5 | 133 | 20 | 20 |

On a position 50 µm away from a position where the ZnO electrode 12 was patterned, the amorphous silicon semiconductor layer 13 and the microcrystalline silicon semiconductor layer 14 were irradiated from the light incident surface with YAG laser so as to be patterned in a rectangle shape. In the laser isolation processing, used was Nd:YAG laser with an energy density of 0.7 J/cm³ and a pulse frequency of 3 kHz.

Next, an Ag electrode 15 having a thickness of 200 nm was formed on the microcrystalline silicon semiconductor layer 14 by sputtering. The Ag electrode 15 was also formed in an area from which the amorphous silicon semiconductor layer 13 and the microcrystalline silicon semiconductor layer 14 were removed by patterning.

On a position 50 µm away from a position where the amorphous silicon semiconductor layer 13 and the microcrystalline silicon semiconductor layer 14 were patterned, part of the Ag electrode 15 and the microcrystalline silicon semiconductor layer 14 were irradiated from the back surface with YAG laser so as to be patterned in a rectangle shape. In the laser isolation processing, used was Nd:YAG laser with an energy density of 0.7 J/cm³ and a pulse frequency of 4 kHz. Further, dry etching by using CF₄ was performed for several tens of seconds. In this manner, in the area by which the Ag electrode was electrically isolated, the amorphous silicon semiconductor layer 13 was left on a surface on the back surface side of the ZnO electrode 12. That is, the amorphous silicon semiconductor layer 13 covers the ZnO electrode 12. In the manner described above, a sub-module in which multiple photovoltaic elements were connected in series was formed on the glass substrate 11.

Next, by using ultrasonic soldering, a copper foil lead was attached as an external electrode.

Subsequently, an EVA 16 and a PET film 17 were disposed in sequence on the photovoltaic element, and were subjected to heat treatment at 150 degrees C for 30 minutes using a laminating apparatus. Thereby, the EVA 16 was bridged, stabilized, and press bonded under vacuum.

Last, a terminal box was attached, and the external electrode was connected. Thereby, the thin-film solar cell module 10 according to one example of the present invention was completed.

### (Conventional Example)

The thin-film solar cell module 50 according to a conventional example was manufactured as follows.

As shown in Fig. 6, on a glass substrate 51 having a thickness of 4 mm, a ZnO electrode 52 having a thickness of 600 nm was formed by sputtering. The ZnO electrode 52 was irradiated with YAG laser from the light incident surface of the glass substrate 51 so that the ZnO electrode 52 would be patterned in a rectangle shape to be electrically isolated. In the laser isolation processing, used was Nd:YAG laser with a wavelength of about 1.06 µm, an energy density of 13 J/cm³, and a pulse frequency of 3 kHz.

Next, by using a plasma CVD method, a microcrystalline silicon semiconductor layer 53 was formed. To be more precise, the microcrystalline silicon semiconductor layer 53 was formed by using a plasma CVD method by stacking in sequence a p-type microcrystalline silicon semiconductor layer, having a film thickness of 10 nm, formed of mixed gas of SiH₄, H₂, and B₂H₆; an i-type microcrystalline silicon semiconductor layer, having a film thickness of 2000 nm, formed of mixed gas of SiH₄ and H₂; and an n-type microcrystalline silicon semiconductor layer, having a film thickness of 20 nm, formed of mixed gas of SiH₄, H₂, and PH₃. Conditions of the plasma CVD method in detail are the same as those of Table 1.

On a position 50 µm away from a position where the ZnO electrode 52 was patterned, the microcrystalline silicon semiconductor layer 53 was irradiated from the light incident surface with YAG laser so as to be patterned in a rectangle shape. In the laser isolation processing, used was Nd:YAG laser with an energy density of 0.7 J/cm³ and a pulse frequency of 3 kHz.

Next, an Ag electrode 54 having a thickness of 200 nm was formed on the microcrystalline silicon semiconductor layer 53 by sputtering. The Ag electrode 54 was also formed in an area from which the microcrystalline silicon semiconductor layer 53 was removed by patterning.

On a position 50 µm away from a position where the microcrystalline silicon semiconductor layer 53 was patterned, the Ag electrode 54 and the microcrystalline silicon semiconductor layer 53 were irradiated from the light incident surface with YAG laser so as to be patterned in a rectangle shape. In the laser isolation processing, used was Nd:YAG laser with an energy density of 0.7 J/cm³ and a pulse frequency of 3 kHz. In this manner, in the area by which the Ag electrode 54 was electrically isolated, the microcrystalline silicon semiconductor layer 53 was removed from a surface on the back surface side of the ZnO electrode 52. That is, in this area, the microcrystalline silicon semiconductor layer 53 does not cover the ZnO electrode 52. In the manner described above, a sub-module in which multiple photovoltaic elements were connected in series was formed on the glass substrate 11.

Next, by using ultrasonic soldering, a copper foil lead was attached as an external electrode.

Subsequently, an EVA 55 and a PET film 56 were disposed in sequence on the photovoltaic element, and were subjected to heat treatment at 150 degrees C for 30 minutes by using a laminating apparatus. Thereby, the EVA was bridged, stabilized, and press bonded under vacuum. Here, the area by which the Ag electrode is electrically isolated is filled with EVA 55, so that the ZnO electrode 52 and EVA 55 are brought into contact with each other.

Last, a terminal box was attached, and the external electrode was connected. Thereby, the thin-film solar cell module 50 according to the conventional example was completed.

### (Reliability Evaluation)

In order to compare the reliability of the thin-film solar cell module 10 according to this example, and that of the thin-film solar cell module 50 according to the conventional example, weather resistance reliability evaluation was carried out. To be more specific, a humidity test was conducted for measuring the rate of change of output characteristics of each module under the circumstances of a temperature of 85 degrees C and a humidity of 85%. Here, the rate of change of output characteristics is obtained by indexing a time change of an output with an output at the time of starting the test set to 1.00.

### (Result)

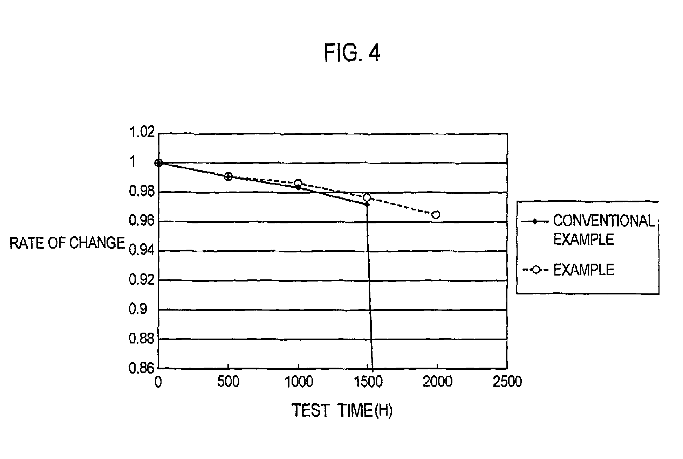

A measurement result is shown in Fig. 4. In Fig. 4, the rate of change of output characteristics of each solar cell module is shown in time series.

In the thin-film solar cell module 50 according to the conventional example, the output therefrom became unstable after about 1000 hours have passed since the start of the test, and the output was sharply reduced after about 1500 hours have passed. Further, after about 1800 hours have passed, the output disappeared.

Meanwhile, in the thin-film solar cell module 10 according to this example, even after 2000 hours have passed since the start of the test, a stable and high output therefrom could be maintained.

In order to find out cause of the result shown in Fig. 4, for the thin-film solar cell module 50 according to the conventional example after the test, the output characteristics were measured for each photovoltaic element. It has been then confirmed that some photovoltaic elements were in a state in which no voltage was outputted, i.e. conductive failure occurred.

Then, when each inside of the photovoltaic elements in which the conductive failure occurred was observed through a microscope, it has been found that the appearance of ZnO coming in contact with the EVA 55 clearly changed. That is, it has been confirmed that the ZnO deteriorated due to moisture.

As described above, the reason why the output of the conventional solar cell module 50 disappeared is estimated that, in the area where the Ag electrodes 54 of the adjacent photovoltaic elements are electrically isolated from each other, moisture having permeated the EVA 55 deteriorated the ZnO electrode 52, so that conductive failure occurred in some photovoltaic elements.

Meanwhile, in the thin-film solar cell module 10 according to this example, in the area where the Ag electrodes 15 of the adjacent photovoltaic elements are electrically isolated from each other, the amorphous silicon semiconductor layer 13 covers the ZnO electrode 12. Therefore, it has been found that moisture having permeated the EVA 16 could be prevented from reaching the ZnO electrode 12, so that the thin-film solar cell module 10 could maintain a stable and high output.

Particularly, an amorphous silicon semiconductor has high impermeability compared with a polycrystalline silicon semiconductor, so that it is capable of blocking moisture having permeated the EVA 16. This is supposed to have contributed largely to allowing the thin-film solar cell module according to this example to maintain a stable and high output.

Further, although having great advantages as the material of the transparent conductive film, ZnO has not been used in practice because of its characteristics of easily deteriorating due to moisture. However, in accordance with the result of the reliability evaluation, it has been found that ZnO can be used in practice by employing the configuration of this example.

Note that, the entire contents of Japanese Patent Application No. 2006-208787 (filed on July 31, 2006) are herein incorporated by reference.

### INDUSTRIAL APPLICABILITY

As has been described above, the thin-film solar cell module according to the present invention is useful since the transparent conductive film can be prevented from being deteriorated by blocking moisture having permeated the module by using the photoelectric conversion layer.

## Claims

1. A solar cell module formed by disposing in sequence a photovoltaic layer and a bonding layer, the photovoltaic layer formed by connecting in series a plurality of photovoltaic elements each of which is formed by stacking in sequence a first electrode, a photoelectric conversion layer, and a second electrode on a transparent substrate on a back surface side opposite to a light incident surface side, wherein,
in an area where the second electrodes of the adjacent photovoltaic elements are electrically isolated from each other, at least a part of the photoelectric conversion layer covers a surface on the back surface side of the first electrode.

2. The solar cell module according to claim 1, wherein the part of the photoelectric conversion layer formed of an amorphous silicon semiconductor.

3. The solar cell module according to claim 1, wherein the first electrode is mainly formed of zinc oxide.

4. The solar cell module according to claim 1, wherein the photovoltaic layer is electrically isolated in each of the plurality of photovoltaic elements by laser patterning.

## Amended claims

### Amended claims under Art. 19.1 PCT

**1.** (Amended) A solar cell module formed by disposing in sequence a photovoltaic layer and a bonding layer, the photovoltaic layer formed by connecting in series a plurality of photovoltaic elements each of which is formed by stacking in sequence a first electrode, a photoelectric conversion layer, and a second electrode on a transparent substrate on a back surface side opposite to a light incident surface side, wherein
the photoelectric conversion layer includes a first photoelectric conversion layer formed of an amorphous silicon semiconductor and a second photoelectric conversion layer formed of a microcrystalline silicon semiconductor, the first and second photoelectric conversion layers arranged in sequence from the back surface side of the transparent substrate, and,
in an area where the second electrodes of the adjacent photovoltaic elements are electrically isolated from each other, the second photoelectric conversion layer is removed, and the first photoelectric conversion layer covers a surface on the back surface side of the first electrode.

**2.** (Cancelled)

**3.** The solar cell module according to claim 1, wherein the first electrode is mainly formed of zinc oxide.

**4.** The solar cell module according to claim 1, wherein the photovoltaic layer is electrically isolated in each of the plurality of photovoltaic elements by laser patterning
